Europäisches Patentamt

European Patent Office

Office européen des brevets

(19)

(11) EP 0 847 141 A1

(12) DEMANDE DE BREVET EUROPEEN

(43) Date de publication:
10.06.1998 Bulletin 1998/24

(51) Int Cl.6: H03K 23/66, H03K 23/68,
H03K 4/02

(21) Numéro de dépôt: 97460048.8

(22) Date de dépôt: 27.11.1997

(84) Etats contractants désignés:
AT BE CH DE DK ES FI FR GB GR IE IT LI LU MC
NL PT SE
Etats d'extension désignés:
AL LT LV MK RO SI

(30) Priorité: 05.12.1996 FR 9615179

(71) Demandeur: SGS-THOMSON
MICROELECTRONICS S.A.
94250 Gentilly (FR)

(72) Inventeurs:
• Gailliard, Thierry
56100 Lorient (FR)
• Dell'Ova, Francis
56100 Lorient (FR)
• Marchand, Benoît
56100 Lorient (FR)

(74) Mandataire: Ballot, Paul et al
Cabinet Ballot-Schmit
4, rue Général Hoche
Boîte Postale 855
56108 Lorient Cédex (FR)

(54) **Dispositif de découpage de la période d'un signal en N parties quasi-égales**

(57) On découpe la période d'un signal d'entrée en N parties en comptant pendant cette période les impulsions délivré par une horloge. On divise ce nombre par N puis on répartit le reste de cette division l'ensemble des N parties de la période du signal d'entrée.

Application à la génération de signaux de balayage en télévision.

FIG_3

EP 0 847 141 A1

## Description

La présente invention a pour objet un dispositif de découpage de la période T d'un signal en N parties quasi-égales. Elle peut trouver son application dans tous les domaines, notamment dans le domaine de la télévision. Dans celui-ci, elle servira de préférence à produire un signal de balayage vertical à partir d'un signal de synchronisation verticale.

L'invention sera décrite dans le contexte du traitement des signaux de télévision pour plus de facilité sans qu'on puisse y voir une quelconque limitation de la portée de l'invention. On connaît, dans les signaux de télévision pour visualiser des images sur des écrans cathodiques, les signaux de balayage vertical ainsi que les signaux de balayage horizontal. Ces signaux de balayage sont issus de signaux de synchronisation verticale et horizontale. Les signaux de balayage sont appliqués sur des bobines de déflexion d'un ou plusieurs canons projetant des électrons d'une cathode vers un écran électroluminescent. Pour constituer une image, on provoque ainsi le balayage de l'écran afin de constituer un certain nombre de lignes empilées les unes en dessous des autres de haut en bas.

Selon la résolution envisagée, ainsi que selon les normes de visualisation utilisées dans les différentes régions du monde, le nombre de lignes visualisées sur l'écran varie. Alors qu'on connaît actuellement des images avec 420 lignes ou 625 lignes, les nouvelles normes prévoient 1024 lignes ou même 2048. Par ailleurs la fréquence de rafraîchissement des images sur l'écran, 25 images par seconde, dépend également des standards et des qualités recherchés. On envisage notamment 100 images par seconde pour éviter les effets de scintillement. Des générateurs de signaux de balayage polyvalents sont donc réalisés pour faire face à ces différents standards.

Ces générateurs de signaux de balayage doivent générer, à partir de signaux de synchronisation, des signaux de balayage en dents de scie dont la période est égale à la période du signal de synchronisation correspondant et dont l'amplitude maximum est constante quelle que soit cette période. Il existe des signaux de synchronisation verticale et de synchronisation horizontale associés respectivement aux signaux de balayage vertical et horizontal. Ces signaux de synchronisation contiennent des informations de temps liées au début d'une ligne et au début d'une trame (ou d'une demi-trame). La période de ces signaux de synchronisation varie donc en fonction de la fréquence de rafraîchissement des images sur l'écran et en fonction du nombre de lignes visualisées sur l'écran.

Jusqu'à présent, uniquement des circuits analogiques tel que le circuit moniteur TDA 9106 de SGS Thomson Microelectronics, réalisent cette fonction. Cependant, de tels circuits présentent une incertitude de l'ordre de 1% sur l'amplitude maximum des signaux de balayage à chaque changement de fréquence du signal de synchronisation. Ainsi, pour deux fréquences de balayage différentes, l'amplitude maximum des deux signaux de balayage peut être différente. La mise en oeuvre de tel circuit nécessite donc un réglage préalable du moniteur suivant la fréquence de rafraîchissement. A chaque changement de standard, par exemple de VGA à SVGA, il faut retoucher le bouton de position verticale de l'image.

Aussi le principal problème que l'invention cherche à résoudre est de proposer un dispositif garantissant une amplitude maximum constante des signaux de balayage, quel que soit le standard employé.

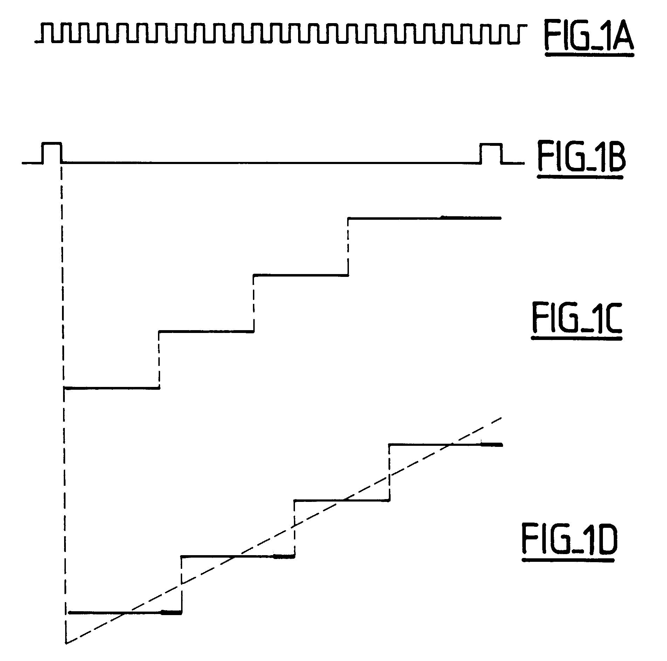

Pour pallier cet inconvénient, on prévoit l'utilisation d'un circuit numérique pour générer les signaux de balayage. La technique employée pour assurer une amplitude maximum constante consiste à découper la période du signal de synchronisation en N parties et d'associer une valeur d'amplitude à chaque partie pour former le signal de balayage. De cette façon, l'amplitude maximum du signal de balayage est fixée par le circuit numérique et ne dépend pas de la période du signal de synchronisation. Les figures 1A à 1D illustrent un exemple de découpage de la période d'un signal de synchronisation verticale VSYNC. Les figures 1A et 1B représentent respectivement un signal d'horloge CK et le signal de synchronisation verticale VSYNC. La figure 1C illustre le cas où la période du signal VSYNC est découpée en 4 parties égales. Dans cet exemple, la période du signal VSYNC est équivalente à 23 périodes d'horloge. Chaque partie est donc équivalente à 5 périodes d'horloge et les 3 périodes d'horloge restantes se juxtaposent à la dernière partie. Cette technique permet donc d'obtenir une amplitude maximum constante quelle que soit la période du signal VSYNC puisque la période est découpée en un nombre fixe de parties, N, et qu'à chaque partie est associée une valeur d'amplitude donnée. Cependant, ce découpage n'est pas satisfaisant car la dernière partie à laquelle se rajoute la partie restante de la période, est disproportionnée par rapport aux autres parties. Après conversion analogique de ce signal, on risque d'obtenir un signal analogique écrêté et cela veut dire que plusieurs lignes vidéo se superposeront sur l'écran. Aussi, la solution consiste à répartir les impulsions d'horloge restantes sur l'ensemble des parties de la période du signal VSYNC. Cette solution est décrite à la figure 1D. La période du signal de synchronisation VSYNC est alors découpée en N parties quasi-égales. Il faut noter qu'en pratique, la période d'un signal de synchronisation verticale sera découpée en un très grand nombre de parties, 4096 par exemple. Certaines de ces parties seront consacrées au retour trame mais ceci ne fait pas l'objet de la présente demande.

Dans l'invention, on veut pouvoir découper la période d'un signal quelconque en N parties quasi-égales. Ce but est atteint dans l'invention en effectuant un comptage, pendant une période choisie du signal de synchronisation, des impulsions délivrées par une horloge suffisamment rapide pour produire beaucoup d'impulsions pendant cette période. On obtient, après ce comptage pendant une première période de durée, un nombre A d'impulsions lié à la fréquence de cette horloge et à la durée de cette période. On divise ensuite ce nombre d'impulsions par le nombre N pour obtenir un nombre B et un nombre R d'impulsions correspondant respectivement au quotient et au reste de la division de A par N. Ces étapes constituent la phase d'acquisition des nombres d'impulsions B et R. Ensuite, on répartit dans les N blocs d'impulsions le nombre R d'impulsions restantes à raison d'une impulsion au maximum par bloc. On précharge ensuite un compteur tantôt avec le nombre B, tantôt avec le nombre B+1 et on décompte des impulsions produites par l'horloge. A chaque fois qu'un bloc de B ou B+1 impulsions est compté, on délivre un signal de fin de bloc et on précharge à nouveau le compteur avec une nouvelle valeur.

L'invention a donc pour objet un dispositif de découpage de la période T d'un signal d'entrée en N blocs quasi-égaux en nombre d'impulsions d'horloge caractérisé en ce qu'il comporte :

- une horloge délivrant un nombre A d'impulsions pendant la période T du signal d'entrée, A étant inférieur ou égal à $2^{P+M}$, avec P et M entiers,
- un premier registre de M bits pour stocker un nombre R d'impulsions égal au reste de la division du nombre A d'impulsions par le nombre N, avec N égal à $2^M$,
- un second registre de P bits pour stocker un nombre B d'impulsions égal au quotient de la division du nombre A d'impulsions par le nombre N,
- un moyen de répartition pour inclure, à chaque période T, à raison d'une impulsion par bloc, R impulsions dans R blocs pris aléatoirement parmi lesdits N blocs d'impulsions de ladite période T,
- un compteur numérique binaire avec P bits dont l'entrée de précharge est connectée à la sortie dudit moyen de répartition délivrant lesdits blocs et dont l'entrée de comptage reçoit les impulsions d'horloge, lequel compteur produit un signal de fin de bloc,

ledit moyen de répartition comprenant:

a) un accumulateur, activé par le signal de fin de bloc dudit compteur, pour produire en sortie un nombre égal à un ou zéro, à raison de R nombres égaux à un sur un ensemble de N nombres, le nombre R étant fourni audit accumulateur par le premier registre, et
b) un additionneur pour additionner le nombre égal à un ou zéro produit par l'accumulateur au nombre B contenu dans le second registre et fournir le nombre somme audit compteur numérique binaire.

Selon l'invention, on produit donc des blocs d'impulsions quasi-égaux comportant B ou B+1 impulsions d'horloge. Dans un mode de réalisation préféré, l'accumulateur comporte :

- un additionneur recevant sur une première entrée le nombre R stocké dans le premier registre, sur une seconde entrée un nombre $S_{i-1}$, et délivrant sur une première sortie le résultat $S_i$ de l'addition du nombre R avec le nombre $S_{i-1}$, et sur une seconde sortie un nombre indiquant le dépassement de capacité de l'additionneur, laquelle seconde sortie est connectée à la sortie de l'accumulateur, et
- un registre comprenant une entrée de données connectée à la première sortie de l'additionneur, une entrée d'activation recevant le signal de fin de bloc dudit compteur, une entrée d'horloge recevant les impulsions de l'horloge et une sortie de données connectée à la seconde entrée de l'additionneur fournissant ledit nombre $S_{i-1}$.

Selon un perfectionnement du mode de réalisation du dispositif, l'accumulateur comporte un générateur de nombres aléatoires connecté à une entrée de précharge du registre de l'accumulateur pour charger dans ledit registre un nombre différent à chaque période T du signal d'entrée. Le fait de précharger au début de chaque période T un nombre différent dans le registre de l'accumulateur va permettre d'éviter des effets de persistance sur un écran de télévision, c'est-à-dire éviter autant que possible que pour deux périodes successives les blocs de même rang comporte B+1 impulsions.

En vue de son utilisation pour générer un signal de balayage en dent de scie, le dispositif de découpage comporte en outre un compteur numérique binaire supplémentaire pour associer un nombre propre à chaque bloc d'impulsions d'une période T correspondant au rang de ce bloc dans ladite période T, lequel compteur supplémentaire reçoit sur son entrée de comptage les signaux de fin de bloc et délivre sur une sortie de données le nombre associé à chaque bloc d'impulsions.

D'autres caractéristiques et avantages de l'invention apparaîtront à la lecture de la description détaillée qui suit et qui est faite en référence aux dessins annexés dans lesquels :

- les figure 1A à 1D, déjà décrites, représentent des diagrammes temporels illustrant le découpage de la période d'un signal de synchronisation verticale en quatre parties quasi-égales;
- la figure 2 est un circuit permettant l'acquisition des nombres B et R;

- la figure 3 est un générateur de signaux de balayage vertical comportant le dispositif de découpage de l'invention; et
- la figure 4 est le schéma d'un accumulateur selon l'invention;

Pour découper le signal d'entrée, qui est ici le signal de synchronisation verticale VSYNC, en N parties quasi-égales, il faut tout d'abord mesurer la période de ce signal puis diviser cette période en N parties égales et répartir la partie restante de la période dans les N parties égales. Dans l'exemple d'application plus particulièrement décrit ici (génération d'un signal de balayage vertical), le nombre N de blocs est choisi de préférence supérieur au nombre de lignes que le moniteur de télévision est susceptible de montrer. Compte tenu du fait que, pour augmenter la résolution des images, ce nombre est en constante augmentation, on a donc choisi N = 4096. On choisit par ailleurs N égal à une puissance de 2 pour que la division par N s'effectue d'une manière très simple.

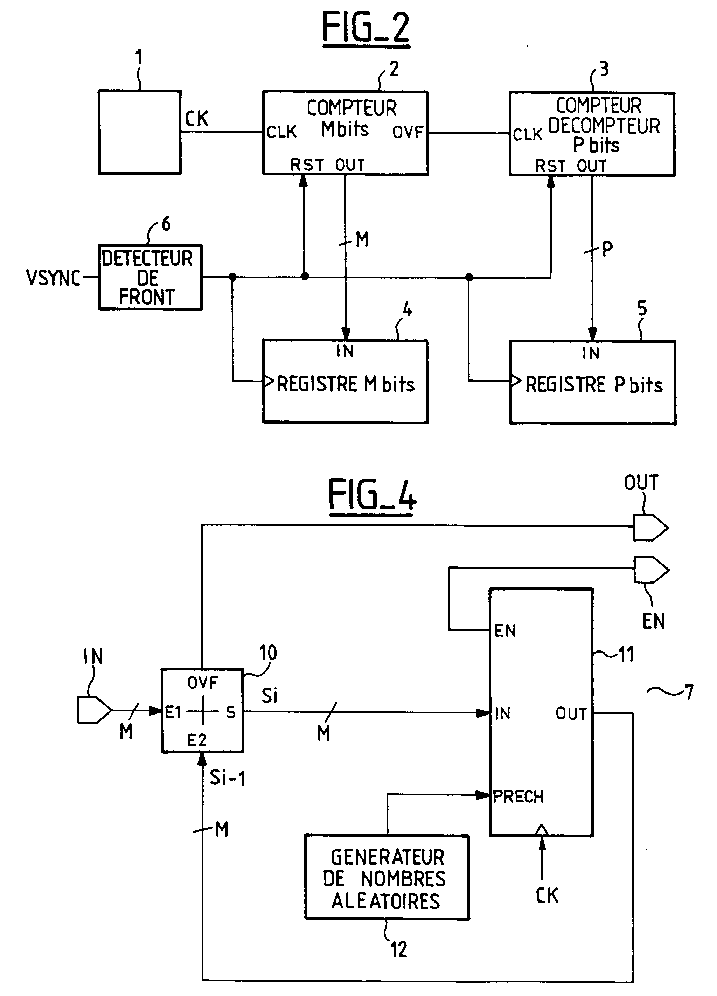

La figure 2 montre un circuit permettant de mesurer la période du signal d'entrée VSYNC et de la diviser par N afin d'obtenir la taille des N parties égales ainsi que celle de la partie restante de la période. Ce circuit effectue donc l'acquisition des nombres B et R. Ce circuit comporte une horloge 1 délivrant un grand nombre A d'impulsions pendant une période choisie du signal VSYNC. On pourra choisir par exemple une horloge 1 oscillant à 24 MHz. Si la période du signal VSYNC est de 20 millisecondes (25 images par secondes), A est alors égal 480 000. Le circuit comporte par ailleurs un premier compteur 2 de M bits dont la sortie de retenue OVF est connectée à l'entrée de comptage CLK d'un second compteur 3 de P bits. M est défini par la relation $N = 2^M$. Le compteur 2 reçoit sur son entrée de comptage le signal d'horloge CK provenant de l'horloge 1 et, chaque fois que son bit le plus fort repasse à zéro, il provoque le comptage d'une unité dans le compteur 3. Si on regarde le comptage pendant une période choisie du signal VSYNC, on constate qu'à l'issue du comptage, le compteur 3 est chargé avec un nombre égal au nombre de fois que le compteur 2 a fait de tours.

Dans l'exemple d'application qui nous intéresse, le signal de synchronisation verticale VSYNC est découpée en 4096 parties; le compteur 2 est donc un compteur 12 bits ($4096=2^{12}$). A l'issue du comptage, le compteur 3 est alors chargé avec un nombre égal au nombre de fois que le compteur 2 a compté jusqu'à 4096. Si la période du signal VSYNC est 20 millisecondes et si la fréquence horloge est 24 MHz, le compteur 2 contient à l'issue du comptage la valeur 768 correspondant au nombre d'impulsions restantes R après division de A par N et le compteur 3 contient la valeur 117 correspondant au nombre B représentant le quotient de la division de A par N. Le compteur 3 emmagasine donc à la fin du comptage le nombre B d'impulsions contenues dans les blocs d'impulsions avant répartition du nombre R dans ces mêmes blocs.

Pour limiter le comptage à une seule période, les compteurs 2 et 3 sont remis à zéro à chaque fois qu'un détecteur de front 6 décèle un front descendant dans le signal de synchronisation VSYNC. Par ailleurs, l'état des compteurs 2 et 3 est sauvegardé dans des registres, respectivement 4 et 5, avant la remise à zéro des compteurs.

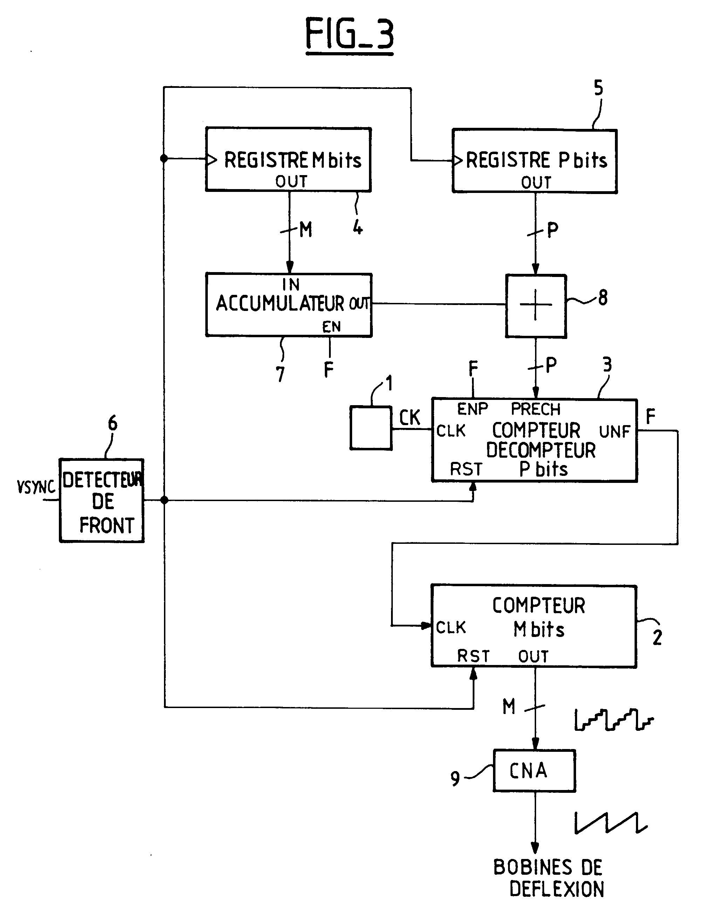

La figure 3 montre un dispositif de découpage de la période T du signal VSYNC en N parties quasi-égales selon l'invention. Ce dispositif reprend notamment les éléments de la figure 2 mais ces éléments sont à présent organisés de manière différente. En pratique, on a affaire à un système à microprocesseur. La réorganisation des connexions est donc assez simple.

Le compteur 3 reçoit à présent sur son entrée de comptage les impulsions CK provenant de l'horloge 1. Ce compteur est en fait un décompteur qui est préchargé avant le décomptage par une valeur somme provenant d'un additionneur 8. Cette valeur somme correspond à la taille d'un bloc d'impulsions après répartition du nombre R et peut être égal soit à B, soit à B+1. En effet, l'additionneur 8 est chargé d'additionner le contenu du registre 5 avec une valeur, 1 ou 0, présente en sortie d'un accumulateur 7. L'accumulateur 7 reçoit en entrée le contenu du registre 4. Le moyen constitué de l'additionneur 8 et de l'accumulateur 7 permet de répartir, à raison d'une impulsion par bloc, R impulsions dans R blocs pris aléatoirement parmi les N blocs d'impulsions de la période du signal VSYNC. La structure de l'accumulateur 7 sera décrite à la figure 4.

Une fois que le compteur 3 est préchargé, il décompte, au rythme des impulsions de l'horloge 1, son contenu jusqu'à atteindre l'état zéro. Lorsque cet état est atteint, il délivre sur une sortie de dépassement UNF (Underflow) une impulsion de fin de bloc F. Autrement dit, à chaque fin de bloc, le compteur 3 délivre un signal de fin de bloc F. Ce signal de fin de bloc F est appliqué d'une part sur une entrée de mise en service EN de l'accumulateur 7 pour que ce dernier délivre sur sa sotie OUT une valeur 1 ou 0, et d'autre part sur une entrée d'autorisation de précharge ENP du compteur 3 pour autoriser la précharge du compteur 3 avec la valeur somme présente en sortie de l'additionneur 8.

Ce signal de fin de bloc est également appliqué sur l'entrée de comptage CLK du compteur 2 qui est un compteur M bits. Le compteur 2 délivre alors pour chaque bloc un nombre de M bits correspondant au rang de ce bloc dans la période du signal VSYNC. L'ensemble des nombres ou mots binaires obtenus à la sortie du compteur 2 constitue alors un signal binaire en dent de scie tel que celui représenté à la figure 1D. Ce signal binaire, pour être exploitable par les bobines de déflexion d'un moniteur ou d'un récepteur de télévision, est ensuite transformé par un convertisseur numérique/analogique 9 puis appliqué sur les bobines de déviation verticale du moniteur.

Dans ce dispositif, l'accumulateur 7 doit être en mesure de délivrer R valeurs égales à 1 sur un ensemble de N valeurs. La figure 4 décrit une structure possible de l'accumulateur 7. L'accumulateur 7 comporte une entrée de données IN, une entrée d'activation EN et une sortie OUT. Il reçoit sur l'entrée IN le nombre R d'impulsions contenu dans le registre 4 et l'entrée EN est connectée à la sortie UNF du compteur 3. Il est constitué d'un additionneur 10 comportant deux entrées de données E1 et E2 sur M bits, une sortie de données S et une sortie de retenue OVF. La sortie de données S est connectée à l'entrée IN d'un registre M bits 11 et la sortie OUT du registre 11 est connectée à l'entrée E2 de l'additionneur 10. L'entrée E1 de l'additionneur 11 est connectée à l'entrée IN de l'accumulateur 7 et sa sortie OVF est connectée à la sortie OUT de l'accumulateur. Enfin, l'entrée d'activation EN de l'accumulateur 7 est reliée à la borne d'activation EN du registre 11.

Ainsi connecté, le registre 11 emmagasine la valeur présente en sortie de l'additionneur 10 à chaque fois que le compteur 3 émet un signal de fin de bloc F.

Pour expliquer le fonctionnement de l'accumulateur 7, on désigne par $S_i$ la valeur obtenue en sortie de l'additionneur 10. Chaque itération i est déclenchée par un signal de fin de bloc F. L'additionneur 10 effectue la fonction suivante:

$$(1) \qquad S_i = (R+S_{i-1}) \bmod N \text{ avec } i \in [1,N] \text{ et } R \in [0,N-1]$$

L'équation (1) signifie alors que:

$$(2) \qquad \exists\, O_i \in \{0,1\} \,/\, R+S_{i-1} = O_{i-1} * N + S_i$$

En effet, par définition $S_i \in [0,N-1]$ et $R \in [0,N-1]$. Dans l'équation (2), $O_i$ représente la retenue de l'additionneur 10 à chaque itération.

Dans la suite, on va démontrer alors que :

$$\sum_{i=0}^{N-1} O_i = R$$

De l'équation (2), en sommant les N équations récurrentes, on peut en déduire que

$$N * R + S_0 = N * \sum_{i=0}^{N-1} O_i + S_N$$

Ce qui donne :

$$(3) \qquad \sum_{i=0}^{N-1} O_i = R * \frac{S_0 + S_N}{N}$$

Par ailleurs, on connaît la propriété suivante :

Soit X, Y et Z entiers naturels, alors
$[X + (Y \bmod Z)] \bmod Z = (X + Y) \bmod Z$

Si on applique N fois cette propriété à l'équation (1), on obtient alors $S_N = (N * R + S_0) \bmod N$
Cette équation se simplifie en $S_N = S_0 \bmod N = S_0$
De l'équation (3), on obtient alors

$$\sum_{i=0}^{N-1} O_i = R$$

Cette démonstration montre que sur un total de N itérations, la retenue $O_i$ sera R fois égale à 1. On rajoute donc systématiquement la retenue $O_i$ au nombre B pour précharger le compteur 3. Ainsi, sur une période du signal VSYNC, le compteur 3 sera préchargé R fois par le nombre B+1 et N-R fois par le nombre B.

Selon un mode de réalisation amélioré, l'accumulateur 7 comporte un générateur de nombres aléatoires 12. La sortie de ce générateur est connectée à l'entrée de précharge du registre 11. Ce générateur va permettre de charger un nombre différent dans le registre 11 à chaque nouvelle période du signal de synchronisation VSYNC et ainsi supprimer les effets de persistance sur l'écran que pourrait engendrer le fait que, pour deux périodes successives, deux blocs de même rang comporte B+1 impulsions.

En pratique, ce générateur de nombres aléatoires 11 peut être un générateur délivrant des séquences de nombres aléatoires basées sur un polynôme à séquence maximale. Le degré de ce polynôme sera choisi en fonction de la longueur de la séquence souhaitée. La longueur de cette séquence sera de préférence égale au nombre N de blocs d'impulsions. Une séquence de longueur supérieure serait inutile. Par exemple, pour obtenir une séquence de 1023 valeurs pseudo-aléatoires, on utilisera le polynôme de degré 10 suivant : $P(x)=1+x^3+x^{10}$. L'implémentation d'un tel polynôme est bien connue de l'homme du métier.

**Revendications**

1. Dispositif de découpage de la période T d'un signal d'entrée en N blocs quasi-égaux en nombre d'impulsions d'horloge caractérisé en ce qu'il comporte :

   - une horloge (1) délivrant un nombre A d'impulsions pendant la période T du signal d'entrée, A étant inférieur ou égal à $2^{P+M}$, avec P et M entiers,
   - un premier registre (4) de M bits pour stocker un nombre R d'impulsions égal au reste de la division du nombre A d'impulsions par le nombre N, avec N égal à $2^M$,
   - un second registre (5) de P bits pour stocker un nombre B d'impulsions égal au quotient de la division du nombre A d'impulsions par le nombre N,
   - un moyen de répartition (7,8) pour inclure, à chaque période T, à raison d'une impulsion par bloc, R impulsions dans R blocs pris aléatoirement parmi lesdits N blocs d'impulsions de ladite période T,
   - un compteur numérique binaire (3) avec P bits dont l'entrée de précharge est connectée à la sortie dudit moyen de répartition (7,8) délivrant lesdits blocs et dont l'entrée de comptage reçoit les impulsions d'horloge, lequel compteur produit un signal de fin de bloc (F),

   ledit moyen de répartition (7,8) comprenant:

   a) un accumulateur (7), activé par le signal de fin de bloc (F) dudit compteur (3), pour produire en sortie un nombre égal à un ou zéro, à raison de R nombres égaux à un sur un ensemble de N nombres, le nombre R étant fourni audit accumulateur (7) par le premier registre (4), et
   b) un additionneur (8) pour additionner le nombre égal à un ou zéro produit par l'accumulateur (7) au nombre B contenu dans le second registre (5) et fournir le nombre somme audit compteur numérique binaire (3).

2. Dispositif de découpage selon la revendication 1, caractérisé en ce que l'accumulateur (7) comporte :

   - un additionneur (10) recevant sur une première entrée (E1) le nombre R stocké dans le premier registre (4), sur une seconde entrée (E2) un nombre $S_{i-1}$, et délivrant sur une première sortie (S) le résultat $S_i$ de l'addition du nombre R avec le nombre $S_{i-1}$, et sur une seconde sortie (OVF) un nombre indiquant le dépassement de capacité de l'additionneur (10), laquelle seconde sortie (OVF) est connectée à la sortie de l'accumulateur (7),
   - un registre (11) comprenant une entrée de données (IN) connectée à la première sortie (S) de l'additionneur (10), une entrée d'activation (EN) recevant le signal de fin de bloc (F) dudit compteur (3), une entrée d'horloge (CLK) recevant les impulsions de l'horloge (1) et une sortie de données (OUT) connectée à la seconde entrée de l'additionneur (10) fournissant ledit nombre $S_{i-1}$.

3. Dispositif de découpage selon la revendication 2, caractérisé en ce que l'accumulateur (7) comporte en outre un générateur de nombres aléatoires (12) connecté à une entrée de précharge (PRECH) du registre (11) pour charger dans ledit registre (11) un nombre différent à chaque période T du signal d'entrée.

4. Dispositif de découpage selon la revendication 2 ou 3, caractérisé en ce qu'il comporte en outre un compteur numérique binaire supplémentaire (2) pour associer un nombre propre à chaque bloc d'impulsions d'une période T correspondant au rang de ce bloc dans ladite période T, lequel compteur supplémentaire (2) reçoit sur son entrée de comptage (CLK) les signaux de fin de bloc (F) et délivre sur une sortie de données (OUT) le nombre associé à chaque bloc d'impulsions.

5. Utilisation du dispositif de découpage selon la revendication 4 comme générateur de signaux de balayage vertical dans le domaine de la télévision.

FIG_1A

FIG_1B

FIG_1C

FIG_1D

## FIG_2

## FIG_4

# FIG_3

Office européen
des brevets

**RAPPORT DE RECHERCHE EUROPEENNE**

Numéro de la demande

EP 97 46 0048

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| X | EP 0 280 126 A (THOMSON BRANDT GMBH) 31 août 1988 | 1-3,5 | H03K23/66 H03K23/68 H03K4/02 |
| Y | * le document en entier * | 4 | |
| Y | US 4 658 406 A (PAPPAS ANDREAS) 14 avril 1987 | 4 | |
| A | * colonne 7, ligne 13 - ligne 59; figure 4 * | 1-3,5 | |
| A | EP 0 322 012 A (PHILIPS NV) 28 juin 1989 * abrégé * | 5 | |
| A | "deflection drive system" IBM TECHNICAL DISCLOSURE BULLETIN, vol. 16, no. 6, novembre 1973, NEW YORK US, page 1765 XP002036211 * le document en entier * | 5 | |

|  |
|---|
| DOMAINES TECHNIQUES RECHERCHES (Int.Cl.6) |
| H03K |

Le présent rapport a été établi pour toutes les revendications

| Lieu de la recherche | Date d'achèvement de la recherche | Examinateur |
|---|---|---|
| LA HAYE | 11 mars 1998 | Segaert, P |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03 82 (P04C02)